(19) 

**Europäisches Patentamt**
**European Patent Office**
**Office européen des brevets**

(11) **EP 4 614 528 A1**

(12) **EUROPEAN PATENT APPLICATION**
published in accordance with Art. 153(4) EPC

(43) Date of publication:
**10.09.2025 Bulletin 2025/37**

(21) Application number: **24738788.9**

(22) Date of filing: **05.01.2024**

(51) International Patent Classification (IPC):
*H01B 7/08* (2006.01)     *H01R 12/78* (2011.01)
*H04M 1/02* (2006.01)     *H01R 12/77* (2011.01)
*H01B 3/46* (2006.01)     *H01B 3/30* (2006.01)
*H05K 1/14* (2006.01)     *H05K 3/28* (2006.01)

(52) Cooperative Patent Classification (CPC):
**H01B 3/30; H01B 3/46; H01B 7/08; H01R 12/77;
H01R 12/78; H04M 1/02; H05K 1/14; H05K 3/28**

(86) International application number:
**PCT/KR2024/095008**

(87) International publication number:
**WO 2024/147720 (11.07.2024 Gazette 2024/28)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **05.01.2023  KR 20230001793
20.01.2023  KR 20230008889**

(71) Applicant: **Samsung Electronics Co., Ltd.
Suwon-si, Gyeonggi-do 16677 (KR)**

(72) Inventors:
• **BAE, Bumhee**
  **Suwon-si Gyeonggi-do 16677 (KR)**
• **YANG, Kwangmo**
  **Suwon-si Gyeonggi-do 16677 (KR)**
• **LEE, Hyung**
  **Suwon-si Gyeonggi-do 16677 (KR)**
• **CHEON, Jeongnam**
  **Suwon-si Gyeonggi-do 16677 (KR)**

(74) Representative: **Gulde & Partner
Patent- und Rechtsanwaltskanzlei mbB
Berliner Freiheit 2
10785 Berlin (DE)**

(54) **STRETCHABLE AND FLEXIBLE FLAT CABLE AND ELECTRONIC DEVICE INCLUDING SAME**

(57)     An embodiment disclosed herein relates to a stretchable cable for transmitting high-speed signals and an electronic device. To this end, the cable may include a stretchable circuit board to which one end of a first printed circuit board is joined by a first pad member and one end of a second printed circuit board is joined by a second pad member, and which is configured to be stretched by an external force in a longitudinal direction pulling the first pad member and the second pad member away from each other. Various other embodiments are possible.

*FIG.6*

**EP 4 614 528 A1**

## Description

[Technical Field]

The disclosure relates to a stretchable flexible flat panel cable that provides high-speed signal transmission, and an electronic device including the same.

[Background Art]

Electronic devices, such as smartphones, tablet PCs, or computers, are becoming smaller, slimmer, or more multifunctional. These electronic devices may include electronic components, such as processor, memory, speaker, microphone, sensor, camera, antenna, or communication module, mounted or connected to a printed circuit board (PCB) or a flexible printed circuit board (FPCB). The PCB or FPCB may include cables connecting the above electronic components to each other.

Further, as the display technology has evolved, research and development of electronic devices with flexible displays has been actively pursued. A flexible display refers to a display that may be folded, bent, rolled, or unfolded, and may be sometimes referred to as a foldable or rollable display.

Electronic devices may have internal space constraints due to a reduction in size or thickness. In such a case, it may be advantageous to use a flexible cable having a relatively thin thickness compared to a coaxial cable in the electronic device. In one example, the flexible cable may be a flexible flat cable (FFC). By providing some degree of flexibility, the flexible cable may provide a variety of options for mounting in the electronic device. The flexibility provided by such a flexible cable may have a flexible property of bending or flexing in a direction perpendicular to the direction in which it extends. However, the flexible cable has difficulty in providing a flexibility property that may stretch in a horizontal direction, that is, its longitudinal direction. For this reason, when the flexible cable is bent to a low radius of curvature, a crack phenomenon may occur.

[Detailed Description of the Invention]

[Technical Problem]

An embodiment of the disclosure may provide a flexible cable configured to include a stretchable section capable of extending in a longitudinal direction and an electronic device to which such a flexible cable is applied.

[Technical Solution]

A cable according to an embodiment of the disclosure may include a stretchable circuit board configured to be stretched by an external force in a longitudinal direction in which a first pad member and a second pad member move away from each other, wherein one end of a first printed circuit board is bonded by the first pad member and one end of a second printed circuit board is bonded by the second pad member. The stretchable circuit board may include a plurality of wiring members configured to be stretched by the external force, one side and another side of which are electrically coupled to the first pad member and the second pad member, respectively, on an upper surface of a direlectric member provided inside a cover member, wherein the plurality of wiring members may be arranged to be spaced apart from each other by a predetermined interval in a width direction perpendicular to the longitudinal direction.

An electronic device according to an embodiment of the disclosure may include a display, housings, at least one bracket, at least one substrate, at least one cable for connecting the at least one substrate or connecting electrical components provided on the at least one substrate, and rear covers. Here, the at least one cable may include a cable stretching in a predetermined direction. The cable stretching in the predetermined direction may include a stretchable circuit board configured to be stretched by an external force in a longitudinal direction in which a first pad member and a second pad member move away from each other, wherein one end of a first printed circuit board is bonded by the first pad member and one end of a second printed circuit board is bonded by the second pad member. The stretchable circuit board may include a plurality of wiring members configured to be stretched by the external force, one side and another side of which are electrically coupled to the first pad member and the second pad member, respectively, on an upper surface of a dielectric member (210) provided inside a cover member, wherein the plurality of wiring members may be arranged to be spaced apart from each other by a predetermined interval in a width direction perpendicular to the longitudinal direction.

[Advantageous Effects]

According to an embodiment of the disclosure, to enable high-speed signal transmission in electronic devices, the durability of flexible cables connecting electronic components can be improved by allowing the cables to bend or stretch in at least some portions.

The technical problem to be addressed in the disclosure is not limited to those mentioned above, and other technical problems not mentioned above may be derived from example embodiments of the disclosure by those having ordinary knowledge in the technical field to which the example embodiments pertain.

Effects that can be obtained from the example embodiments of the disclosure may be clearly derived and understood by those having ordinary knowledge in the technical field to which the example embodiments of the disclosure pertain from the following description. In other words, unintended effects according to implementing the example embodiments of the disclosure may also be derived by those having ordinary knowledge in the technical field to which the example embodiments pertain from the example embodiments of the disclosure.

[Brief Description of Drawings]

FIG. 1 is a front view of a cable according to one embodiment.
FIG. 2 is an enlarged view of a portion of a cable (e.g., a portion I of FIG. 1) and a cross-sectional view taken in a width direction along line A-A', according to one embodiment.
FIG. 3 is a cross-sectional view and an enlarged view of a portion of a second wiring member (e.g., a second wiring member of FIG. 2) before a cable is stretched, according to one embodiment.
FIG. 4 is an enlarged view of a portion of a cable (e.g., a portion I of FIG. 1), and a cross-sectional view thereof taken along line B-B' in a longitudinal direction, according to one embodiment.
FIG. 5 is a perspective view of a cable before it is stretched and after it is stretched, according to one embodiment.
FIG. 6 is a transverse cross-sectional view of a stretchable circuit board before stretching and a transverse cross-sectional view of the stretchable circuit board after stretching, according to one embodiment.
FIG. 7 is an enlarged view of a portion of a transverse cross-sectional view (e.g., a portion III of FIG. 6), according to one embodiment.
FIG. 8 is a longitudinal cross-sectional view of a stretchable circuit board before stretching and a longitudinal cross-sectional view of the stretchable circuit board after stretching, according to one embodiment.
FIG. 9 is an exploded perspective view of an electronic device 1, according to one embodiment.

With regard to the description of the drawings, the same or similar reference numerals may be used for identical or similar components.

[Mode for Carrying out the Invention]

Hereinafter, an embodiment of the disclosure will be described in detail with reference to the drawings so that a person having ordinary knowledge in the technical field to which the example embodiments pertain (hereinafter, referred to as "those skilled in the art) may easily implement the disclosure invention. However, the disclosure may be implemented in a number of different forms and is not limited to the embodiments described herein. With regard to the description of the drawings, the same or similar reference numerals may be used for the same or similar components. Further, in the drawings and their related descriptions, descriptions of well-known functions and configurations may be omitted for clarity and conciseness.

As used herein, the terms used in this document have selected general terms that are currently widely and possibly used, taking into account the functions of the present disclosure, but they may vary depending on the intentions or precedents of those skilled in the art, or the emergence of new technologies, etc. Therefore, the terms used in this document should be defined based on the meaning of the terms and the overall content of the disclosure, not just the names of the terms.

In various embodiments of the disclosure, when a certain portion is described to "includes or comprises" a component, it may imply that the portion may further contain any other components, rather than excluding the other components, unless specifically dictated otherwise.

The term "... unit" or "... module" used in various embodiments of the disclosure may refer to a unit that processes at least one function or operation, which may be implemented in hardware, software or firmware, or a combination of hardware, software or firmware.

The terms "x-axis direction", "y-axis direction", or "z-axis direction" used in the disclosure are defined based on the drawings for convenience of explanation, and the shape or position of each component is not limited by these terms.

The term 'flexibility' described in the disclosure may be understood as bending or flexing in a direction that is not parallel to an x-y plane in electrical components extending on the x-y plane (e.g., cables, printed circuit boards), and stretchability may be understood as stretching or shrinking in a direction that is parallel to the x-y plane in the electrical components extending on the x-y plane.

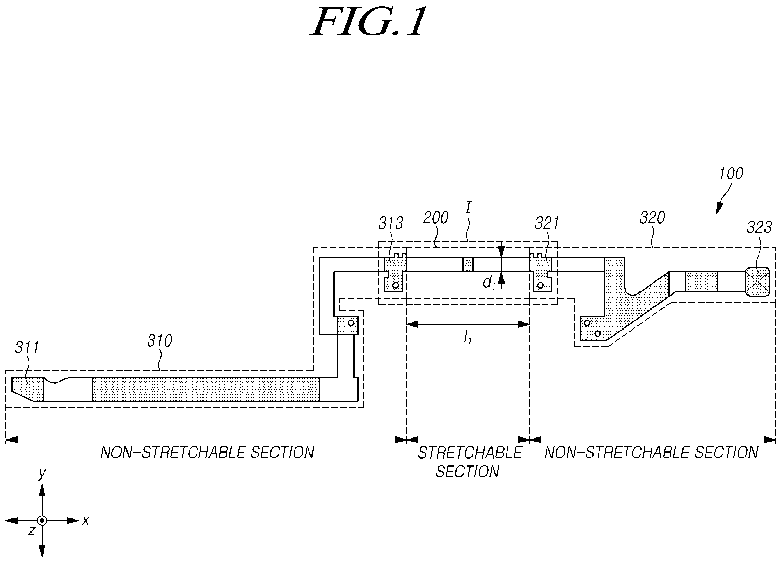

FIG. 1 is a front view of a cable according to one embodiment.

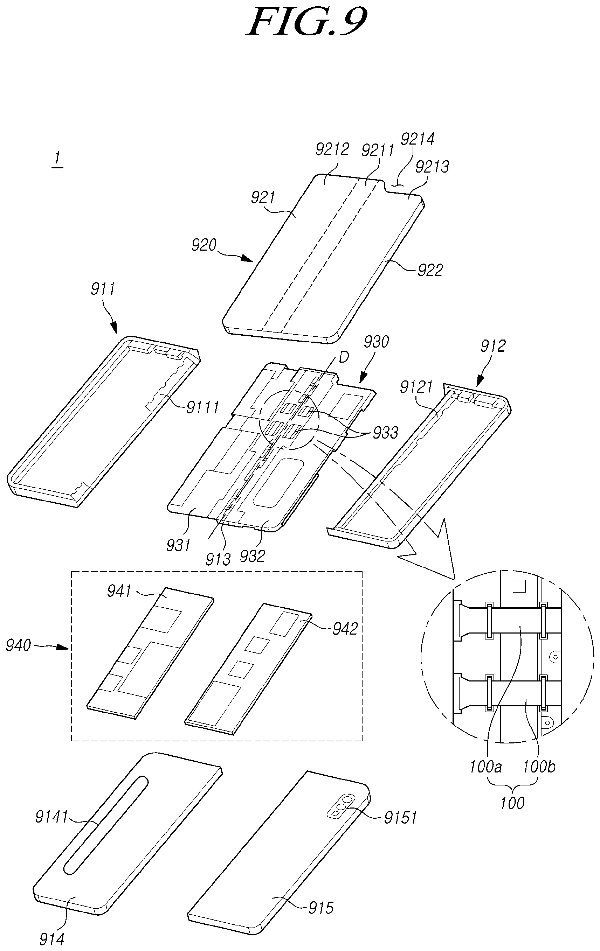

Referring to FIG. 1, a cable 100 may include at least one of cables applied to an electronic device (e.g., an electronic device 1 of FIG. 9). For example, the cable 100 may include at least one of an RF cable, a connection cable, or a flexible flat cable (FFC) applied to the electronic device 1. In addition, the cable 100 may include a member for physically or electrically connecting electrical components composing the electronic device 1. The cable 100 is not limited to the illustrated shape, and may have various shapes according to the purpose of being applied to the electronic device 1.

According to an example, the cable 100 may have various dimensions in a length direction (x-axis direction), a width direction (y-axis direction), or a height direction (z-axis direction). The dimension in the length direction, width direction, or height direction may be set, for example, in consideration of an impedance of the cable 100. The dimension in the length direction, width direction, or height direction may be set, for example, in consideration of a distance between electrical components to be connected by the cable 100.

For example, the cable 100 may have a predetermined length in the longitudinal direction. The predetermined length may be determined, for example, in consideration of a separation distance between the electric components making up the electronic device 1.

For example, the cable 100 may have a predetermined width in the width direction. The width may be determined, for example, in consideration of a speed of signals transmitted between the electrical components making up the electronic device 1, a space inside the electronic device 1, or an impedance value of the cable 100.

For example, the cable 100 may have a predetermined height in the height direction. The height may be determined, for example, in consideration of a speed of signals transmitted between the electrical components making up the electronic device 1, a space inside the electronic device 1, or an impedance value of the cable 100.

According to an example, the cable 100 may include at least one stretchable section or at least one non-stretchable section. The at least one stretchable section may be formed, for example, by a stretchable printed circuit board 200. The at least one non-stretchable section may be formed, for example, by flexible printed circuit boards (FPCBs) 310 and 320.

According to an example, the cable 100 may include a bonding portion in which the stretchable section and the non-stretchable section overlap. The bonding portion may be, for example, a portion that is bonded to electrically couple the stretchable section and the non-stretchable section. When the bonding portion included in the stretchable section and the bonding portion included in the non-stretchable section face each other to be bonded, a section in which such bonding is made may be referred to as a bonding section. The bonding section may correspond to an intersection between the stretchable section and the non-stretchable section. For example, a bonding pad may be provided on the bonding portion included in the stretchable section. For example, a bonding pad may be provided on the bonding portion included in the non-stretchable section. For example, the bonding pad of the stretchable section may be bonded to the bonding pad of the non-stretchable section, using an anisotropic conductive film (ACF) or a ball grid array (BGA).

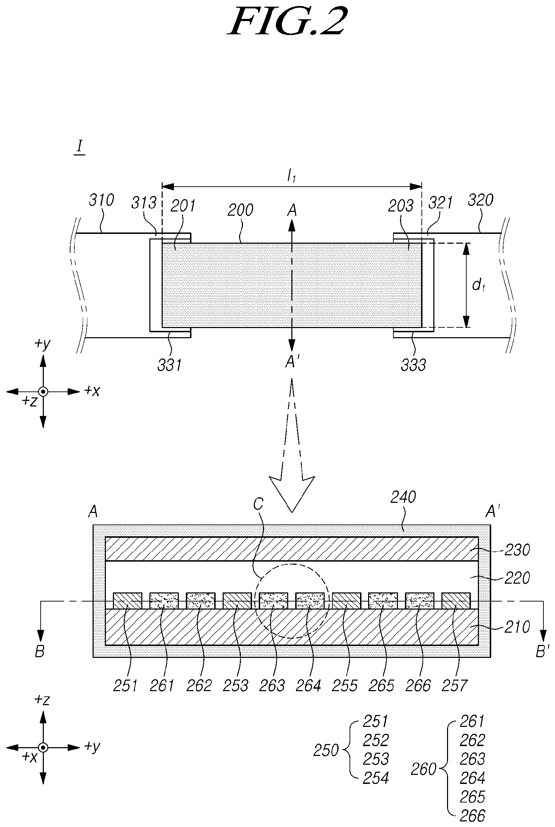

According to an example, the cable 100 may include a first flexible printed circuit board (hereinafter, first FPCB) 310, a second flexible printed circuit board (hereinafter, referred to as a second FPCB) 320, or a stretchable printed circuit board 200. One end 313 of the first FPCB 310 may be electrically or physically connected to one end of the stretchable printed circuit board 200. The other end 311 of the first FPCB 310 may be used as a terminal for inputting or outputting an electrical signal. One end 321 of the second FPCB 320 may be electrically or physically connected to the other end of the stretchable printed circuit board 200. The other end 323 of the second FPCB 320 may be used as a terminal for inputting or outputting an electrical signal. For example, one end or the other end of the stretchable printed circuit board 200 and the one ends 313 and 323 of the first FPCB 310 or the second FPCB 320 may be physically connected to each other by a pad member (e.g., a first pad member 331 or a second pad member 333 of FIG. 2), respectively. In this connection, it will be described in greater detail with reference to FIG. 2.

According to an example, the stretchable printed circuit board 200 may extend in a predetermined direction. In other words, the stretchable printed circuit board 200 may have relatively high elongation. For example, when the first FPCB 310 is pulled in -x-axis direction or the second FPCB 320 is pulled in x-axis direction, the stretchable printed circuit board 200 may extend in a longitudinal direction (e.g., -x-axis or +x-axis direction). Although not shown herein, when the stretchable printed circuit board 200 is pulled in a width direction (e.g., +y-axis or -y-axis direction), the stretchable printed circuit board 200 may extend in the width direction (e.g., +y-axis or -y-axis direction). Although not shown herein, when the stretchable printed circuit board 200 is pulled in a height direction (e.g., +z-axis or -z-axis direction), the stretchable printed circuit board 200 may extend in the height direction (e.g., +z-axis or -z-axis direction). That is, the stretchable printed circuit board 200 may be a circuit board with predetermined elasticity that may extend to a threshold range. A lengthwise section provided by the stretchable printed circuit board 200 may be referred to as a stretchable section of the cable 100.

According to an example, the first FPCB 310 or the second FPCB 320 may be bent in a predetermined direction (e.g., +y-axis or -y-axis direction), but it may have limitations in extending in a predetermined direction (e.g., -x-axis or +x-axis direction). In other words, the first FPCB 310 or the second FPCB 320 may have relatively high flexibility, while it may have relatively low elongation. A lengthwise section provided by the first FPCB 310 or the second FPCB 320 may be referred to as a non-stretchable section of the cable 100.

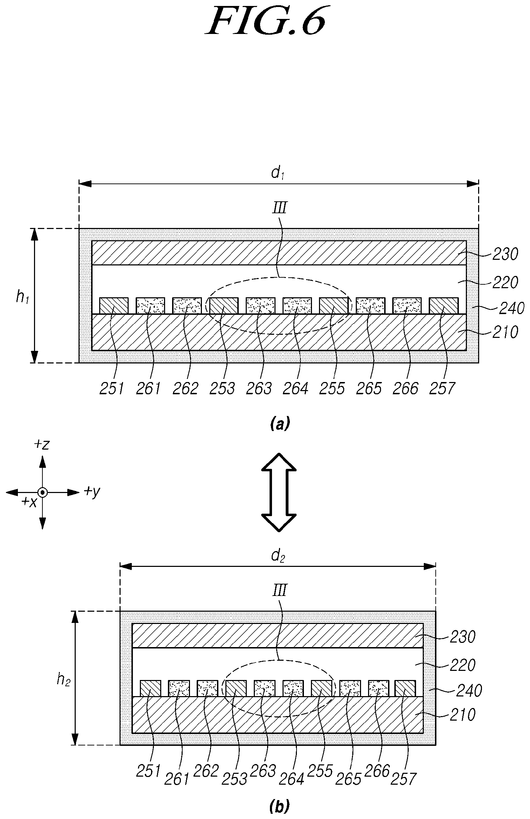

According to an example, the stretchable printed circuit board 200 may have a length $l_1$ and a width $d_1$ with no external force applied thereto. Although not shown herein, the stretchable printed circuit board 200 may have a height $h_1$ (for example, a height $h_1$ in FIG. 6) with no external force applied thereto.

As an example, at least one of the cable 100 and the stretchable printed circuit board 200 may be implemented as a co-planar waveguide (hereinafter, CPW). As an example, a signal transmission line (e.g., a second wiring member 260 of FIG. 2) may be provided on one side of the CPW. As an example, a ground line (e.g., a first wiring member 250 of FIG. 2) may be provided on the other side of the CPW. As an example, a signal transmission line and a ground line may be provided on one side of the CPW. The signal transmission line and/or the ground line may be provided on one surface of the CPW in a microstrip form. The signal transmission line and/or the ground line may be provided, for example, by means of printing (coating) on the CPW. Hereinafter, the cable 100 or the stretchable printed circuit board 200 of the disclosure will be described, on the premise that the signal transmission line and/or the ground line are provided together on one side of the CPW. However, the following description of operation and/or configuration thereof may be applied in the same way to the cable 100 or the stretchable printed circuit board 200 in which a transmission line and/or a ground line are provided in another form.

FIG. 2 is an enlarged view of a portion (e.g., a portion I of FIG. 1) of a cable (e.g., the cable 100 of FIG. 1) and a cross-sectional view taken along line A-A' in a width direction, according to an embodiment of the disclosure.

Referring to an enlarged view of FIG. 2, a portion (e.g., a portion I of FIG. 1) of the enlarged cable 100 may be a portion including a stretchable printed circuit board (e.g., the stretchable printed circuit board 200 of FIG. 1) disposed between the first FPCB (e.g., the first FPCB 310 of FIG. 1) and the second FPCB (e.g., the second FPCB 320 of FIG. 1) in the cable 100. One end 201 of the stretchable printed circuit board 200 may be physically or electrically connected to one end 313 of the first FPCB 310. The other end 203 of the stretchable printed circuit board 200 may be physically or electrically connected to one end 321 of the second FPCB 320.

According to an example, one end 201 of the stretchable printed circuit board 200 may be physically or electrically connected to one end 313 of the first FPCB 310 by a first pad member 331. The other end 203 of the stretchable printed circuit board 200 may be physically or electrically connected to one end 321 of the second FPCB 320 by a second pad member 333. The first pad member 331 may be made of, for example, a conductive material such as a metallic material. The second pad member 333 may be also made of, for example, a conductive material such as a metallic material.

According to an example, the first pad member 331 or the second pad member 333 may have a predetermined area that may be defined by a horizontal length and a vertical length. For example, the first pad member 331 may have a width substantially less than a width corresponding to a vertical length of the one end 313 of the first FPCB 310. Unlike the illustration, the first pad member 331 may have a width substantially the same vertical length as a width corresponding to a vertical length of the one end 313 of the first FPCB 310. The first pad member 331 may have a width substantially greater than a width $d_1$ of the stretchable printed circuit board 200. Unlike the illustration, the first pad member 331 may have a width substantially less than or equal to a width $d_1$ of the stretchable printed circuit board 200. For example, the second pad member 333 may have a width substantially less than a width corresponding to a vertical length of the one end 321 of the second FPCB 320. Unlike the illustration, the second pad member 333 may have a width substantially the same vertical length as a width corresponding to a vertical length of the one end 321 of the second FPCB 320. The second pad member 333 may have a width substantially greater than the width $d_1$ of the stretchable printed circuit board 200. Unlike the drawing, the second pad member 333 may have a width substantially less than or equal to the width $d_1$ of the stretchable printed circuit board 200.

For example, the first pad member 331 may be disposed on an upper surface near one end 313 of the first FPCB 310 or on a lower surface near one end 201 of the stretchable printed circuit board 200. The first pad member 331 may physically or electrically connect the upper surface near the one end 313 of the first FPCB 310 to the lower surface near the one end 201 of the stretchable printed circuit board 200. The first pad member 331 may include at least one adhesive member.

For example, when the first pad member 331 is formed of one adhesive member, the lower surface of the first pad member 331 may be physically or electrically connected to the upper surface at one end 313 of the first FPCB 310, and the upper surface of the first pad member 331 may be physically or electrically connected to the lower surface at one end 201 of the stretchable printed circuit board 200.

For example, when the first pad member 331 is formed of two adhesive members, one adhesive member may be physically or electrically connected to the upper surface at one end 313 of the first FPCB 310, and the other adhesive member may be physically or electrically connected to the lower surface at one end 201 of the stretchable printed circuit board 200. The adhesive member connected to the upper surface at one end 313 of the first FPCB 310 may be connected to the adhesive member connected to the lower surface at one end 201 of the stretchable printed circuit board 200.

According to an example, the second pad member 333 may be disposed on the upper surface near one end 321 of the second FPCB 320 and/or the lower surface near the other end 203 of the stretchable printed circuit board 200. The second pad member 333 may physically or electrically connect the upper surface near one end 321 of the second FPCB 320 and the lower surface near the other end 203 of the stretchable printed circuit board 200. The second pad member 333 may include at least one adhesive member.

For example, when the second pad member 333 is configured of one adhesive member, the lower surface of the second pad member 333 may be physically or electrically connected to the upper surface at one end 321 of the second FPCB 320, and the upper surface of the second pad member 333 may be physically or electrically connected to the lower surface at the other end 203 of the stretchable printed circuit board 200.

For example, when the second pad member 333 is configured of two adhesive members, one adhesive member may be physically or electrically connected to the upper surface at one end 321 of the second FPCB 320, and the other adhesive member may be physically or electrically connected to the lower surface at the other end 203 of the stretchable printed circuit board 200. The adhesive member connected to the upper surface at one end 321 of the second FPCB 320 may be connected to the adhesive member connected to the lower surface at the other end 203 of the stretchable printed circuit board 200.

According to an example, the first pad member 331 may connect the stretchable printed circuit board 200 to the first FPCB 310, using any one of ACF method or BGA method. The second pad member 333 may connect the stretchable printed circuit board 200 to the second FPCB 320, using any one of ACF method or BGA method.

For example, the ACF-type bonding is a method of bonding a target object using a thin film in which a non-conductive adhesive and conductive fine particles are mixed. The ACF-type bonding may provide a path through which an electrical signal flows between the first FPCB 310 and the stretchable printed circuit board 200, and/or between the stretchable printed circuit board 200 and the second FPCB 320. Here, the conductive fine particles may be produced, for example, by coating a polymer particle with a metal material including gold (Au), nickel (Ni), or palladium (Pd). The conductive fine particles may have a diameter of, for example, 3 to 15 micrometers (um). The volume of the conductive fine particles may, for example, account for substantially 0.5 to 5% of the total volume of the ACF.

For example, the BGA-type bonding is a method of bonding a target object using solder balls arranged in a plurality of rows and columns onto one surface of a component to be bonded. The BGA-type bonding may provide a path through which an electrical signal flows between the first FPCB 310 and the stretchable printed circuit board 200, and/or between the stretchable printed circuit board 200 and the second FPCB 320. Here, the solder balls may have various shapes including, for example, a spherical shape or a hemispherical shape. The solder balls may be made of, for example, a conductive metal material.

Referring to a cross-sectional view of FIG. 2, for example, a cross-section of the stretchable printed circuit board 200, as cut along the line A-A' and viewed in the -x-axis direction, may include a dielectric member 210, an adhesive member 220, a shielding member 230, a cover member 240, or wiring members 250 and 260. The stretchable printed circuit board 200 may omit at least some of the aforementioned components or include additional components as required.

According to an example, the dielectric member 210 may be made of a non-conductive material. The dielectric member 210 may have a predetermined permittivity. The dielectric member 210 may be made of a material having relatively high flexibility and/or elongation property. For example, the dielectric member 210 may include an epoxy, polymer, or polyurethane-based material. The dielectric member 210 may be made of, for example, a non-conductive material including silicon rubber or polyimide. However, the disclosure is not limited thereto, and the dielectric member 210 may be made of a non-conductive material having a predetermined permittivity.

According to an example, the adhesive member 220 may be a film-type adhesive member. The adhesive member 220 may be made of a material having predetermined flexibility and/or elongation property. The adhesive member 220 may be disposed onto an upper side of the dielectric member 210 with respect to the z-axis. The adhesive member 220 may include, for example, an epoxy-based adhesive, a polymer adhesive, or a polyurethane-based adhesive. The adhesive member 220 may be made of, for example, a non-conductive material including silicon rubber or polyimide. However, the disclosure is not limited thereto, and the adhesive member 220 may be made of a non-conductive material having a predetermined permittivity. The adhesive member 220 may be a thermoplastic adhesive having an adhesive property at room temperature.

According to an example, the shielding member 230 may be provided to protect the wiring members 250 and 260. The shielding member 230 may have a predetermined permittivity. The shielding member 230 may be made of a material having relatively high flexibility and/or elongation property. For example, the shielding member 230 may include an epoxy, a polymer, or a polyurethane-based material. The shielding member 230 may be made of, for example, a non-conductive material including silicon rubber or polyimide. However, the disclosure is not limited thereto, and the shielding member 230 may be made of a non-conductive material having a predetermined permittivity.

According to an example, the cover member 240 may be provided to form an outer appearance of the cable 100. The cover member 240 may provide physical protection for the internal structure of the cable 100 or the stretchable printed circuit board 200. The cover member 240 may be formed of a material having predetermined flexibility and elongation property. The cover member 240 may have shielding or insulation property optically or electrically.

According to an example, the wiring members 250 and 260 may be provided as a path for transmitting signals through the cable 100. For example, the wiring members 250 and 260 may provide a path for the electrical signals flowing from one end 313 of the first FPCB 310 to one end 321 of the second FPCB 320. For example, the wiring members 250 and 260 may provide a path for the electrical signals flowing from one end 321 of the second FPCB 320 to one end 313 of the first FPCB 310. The wiring members 250 and 260 may include a first wiring member 250 or a second wiring member 260.

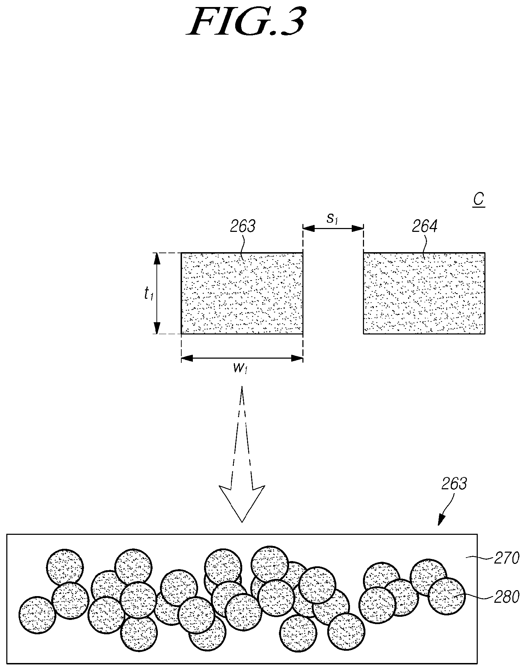

According to an example, the wiring members 250 and 260 may be provided by printing on the upper surface of the dielectric member 210 at a certain interval (e.g., a separation distance $s_1$ between the wiring members 250 and 260 of FIG. 3).

For example, in transmitting a substantial signal generated from an electrical component connected through the cable 100 via the second wiring member 260, the first wiring member 250 may be provided to ground the electrical signal. For example, the direction of the electrical signal moving via the first wiring member 250 may face the direction of the electrical signal moving via the second wiring member 260. For example, the first wiring member 250 may include a first ground wiring 251, a second ground wiring 253, a third ground wiring 255, or a fourth ground wiring 257. The second wiring member 260 may include a first signal wiring 261, a second signal wiring 262, a third signal wiring 263, a fourth signal wiring 264, a fifth signal wiring 265, or a sixth signal wiring 266. The present disclosure is not limited to those illustrated herein, and the first wiring member 250 or the second wiring member 260 may include at least one wiring member or a plurality of wiring members depending on the type or area of the cable 100.

According to an example, the wiring members 250 and 260 may be provided on the upper surface of the dielectric member 210. For example, the first wiring member 250 or the second wiring member 260 may be arranged along the x-axis on the upper surface of the dielectric member 210. The first wiring member 250 or the second wiring member 260 may be alternately arranged. For example, at least one signal wiring may be arranged between adjacent ground wirings among a plurality of ground wirings included in the first wiring member 250. For example, at least one ground wiring may be arranged between adjacent ground wirings among a plurality of signal wirings included in the second wiring member 260.

FIG. 3 is a cross-sectional view and an enlarged view of a portion of the second wiring member (e.g., the second wiring member 260 of FIG. 2) before the cable 100 is stretched, according to one embodiment. While FIG. 3 shows only a third signal wiring (e.g., the third signal wiring 263 of FIG. 2) and a fourth signal wiring (e.g., the fourth signal wiring 264 of FIG. 2), the same description may be also applied to the wiring included in the remaining signal wiring (e.g., the first wiring member 250 or the second wiring member 260) shown in FIG. 2.

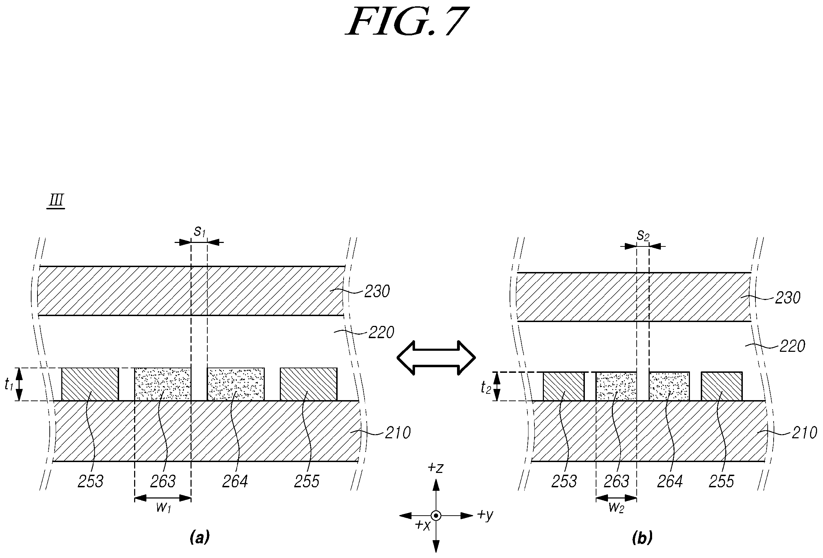

Referring to FIG. 3, the third signal wire 263 may have a width of $w_1$ in a horizontal direction (or a width direction) and a height of $t_1$ in a vertical direction (or a height direction). The third signal wire 263 may be spaced apart from the fourth signal wire 264 at a predetermined interval s1. When the cable 100 is stretched, the width or height of wiring, or spacing between wirings may change. In this regard, description will be made in greater detail with reference to FIG. 7.

According to an example, the wiring members 250 and 260 may have a predetermined stretchability and may be conductive as well. For example, the wiring members 250 and 260 may include a stretchable material 270 or a conductive material 280.

For example, the stretchable material 270 may be a material having relatively high flexibility and/or stretchability. For example, the stretchable material 270 may include an epoxy, polymer, or polyurethane-based material. The stretchable material 270 may be made of, for example, a non-conductive material including silicon rubber or polyimide. However, the present disclosure is not limited thereto, and the stretchable material 270 may be made of a non-conductive material having a predetermined dielectric permittivity.

For example, the conductive material 270 may be present in the wiring members 250 and 260 in a powder form. The conductive material 270 may be made of a metal material having a relatively high conductivity. The conductive material 270 may be made of, for example, silver, but the disclosure is not limited thereto.

According to an example, the stretchable material 270 or the conductive material 280 included in the wiring members 250 and 260 may be set to a predetermined density. The conductive material 280 included in the wiring members 250 and 260 may be maintained at the above-set mass per unit volume or molecular weight per unit volume

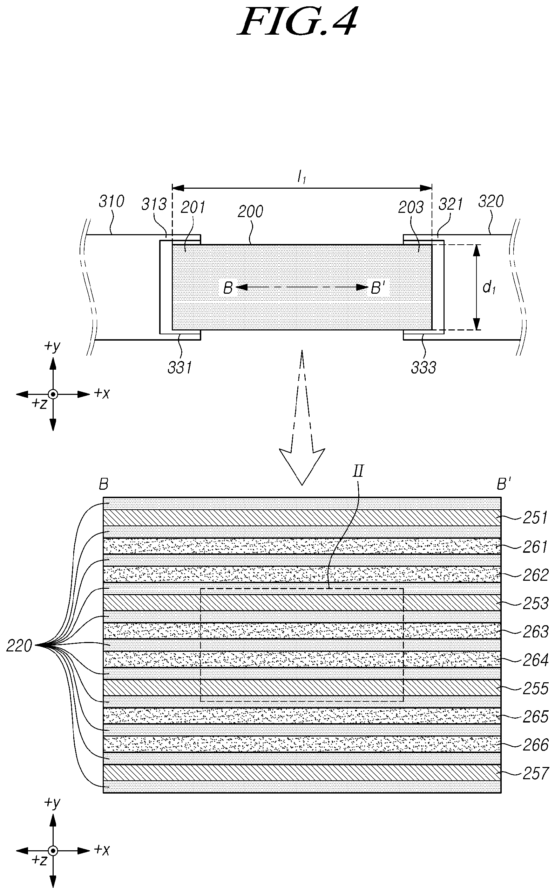

FIG. 4 is an enlarged view of a portion (e.g., the portion I of FIG. 1) of a cable (e.g., the cable 100 of FIG. 1) and a cross-sectional view thereof taken along line B-B' in a longitudinal direction, according to an embodiment of the disclosure The enlarged view of FIG. 4 may be substantially the same as the enlarged view of FIG. 2 described above. Accordingly, in the following description, a structure or configuration in the enlarged view of FIG. 4 different from that of the enlarged view of FIG. 2 described above will be mainly described. In FIG. 4, the cross-sectional view is a longitudinal cross-sectional view taken along the line B-B' in a longitudinal direction, and may be a cross-sectional view taken parallel to the x-y plane at a predetermined height (e.g., a predetermined height located between the dielectric member 210 and the wiring members 250 and 260) in the transverse cross-sectional view of FIG. 2.

Referring to the cross-sectional view of FIG. 4, for example, a cross-section in which the stretchable printed circuit board 200 is cut in a lengthwise direction along the line B-B' and then viewed in the +y-axis direction may have a structure in which a first wiring member 250 and a second wiring member 260 are arranged on the dielectric member 210 along the x-axis. The first and second wiring members 250 and 260 may be spaced apart from each other by $s_1$ on a pre-stretch basis. The second wiring member 260 may be a wiring through which an electrical signal is transmitted between electrical components connected through the cable 100. The first wiring member 250 may be a wiring for providing a ground in transmitting an electrical signal to the second wiring member 260. A direction of the signal flowing through the first wiring member 250 may be opposite to a direction of the signal flowing through the second wiring member 260. An inductance coefficient (hereinafter, referred to as inductance) by the first and second wiring members 250 and 260 may be determined by a length $l_1$, a width $d_1$, and a height $h_1$ of the first and second wiring members 250 and 260. Hereinafter, inductance according to a signal (e.g., current) flowing through the wiring members 250 and 260 before the cable 100 is stretched will be defined as $L_1$.

According to an example, the adhesive member 220 may be provided around the wiring members 250 and 260. The adhesive member 220 may physically bond the dielectric member 210 and the shielding member 230. The adhesive member 220 may be provided to fix the wiring members 250 and 260 printed on the upper surface of the dielectric member 210. As the dielectric member 210 and the adhesive member 230 are made of a non-conductive material, its capacitance (hereinafter, referred to as C) may be defined by the separation distance $s_1$ between the wiring members 250 and 260. Hereinafter, the capacitance between the wiring members 250 and 260 before the cable 100 is stretched will be defined as C1.

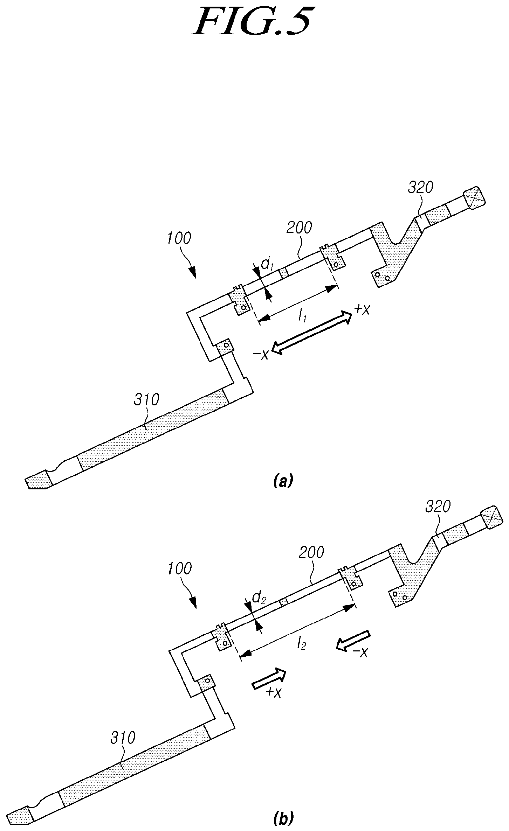

FIG. 5 is a perspective view showing states before (a) and after (b) a cable (e.g., the cable 100 of FIG. 1) is stretched.

Referring to FIG. 5, since the cable 100 in the state (a) is the same as that in FIG. 1, any redundant description thereof will be omitted. The stretchable printed circuit board 200 corresponding to an elongated section in the cable 100 may be elongated in the longitudinal direction (e.g., the x-axis direction). For example, the stretchable printed circuit board 200 has predetermined elongation, and thus may extend in a direction in which both ends (e.g., both ends 201 and 203 of FIG. 2) of the stretchable printed circuit board 200 move away from each other. In such a case, the cable 100 may be elongated such that both ends 201 and 203 of the stretchable printed circuit board 200 are moved away up to a threshold point. When the stretchable printed circuit board 200 is elongated, the lengths of the first FPCB 310 and the second FPCB 320 corresponding to the non-elongated period may not increase or decrease in the longitudinal direction.

According to an example, it is shown that the cable 100 in the state (b) is stretched to a critical point. The cable 100 stretched to the critical point may extend the length of the stretchable printed circuit board 200 to $l_2$. As the stretchable printed circuit board 200 is stretched, the width may be reduced to $d_2$. For example, $l_2$ may be greater than $l_1$, and $d_2$ may be less than $d_1$. For example, $l_2$ may be equal to $l_1$, and $d_2$ may be less than $d_1$. For example, $l_2$ may be greater than $l_1$, and $d_2$ may be equal to $d_1$. Both the ends 201 and 203 of the stretchable printed circuit board 200 may shrink in the longitudinal direction and return to the cable 100 in the state (a) again, when the tension acting in the longitudinal direction is removed. When the stretchable printed circuit board 200 is contracted, the lengths of the first FPCB 310 and the second FPCB 320 may not increase or decrease in the longitudinal direction.

According to an example, the degree to which the stretchable printed circuit board 200 in the state (a) is stretched to the state (b) or the degree to which the stretchable printed circuit board 200 in the state (b) is contracted to the state (a) may be determined based on the induction coefficient and the capacitance present in the wiring members (e.g., the wiring members 250 and 260 of FIG. 2) provided on the stretchable printed circuit board 200. In order to transmit a high-speed signal via the cable 100, impedance matching must be performed. For example, when it is assumed that a reference impedance of the electrical components mounted in the electronic device 1 is 50 ohm $(\Omega)$, a difference in impedance between the cable 100 in the state (a) and the cable 100 in the state (b) should be within a predetermined ratio of the reference impedance. The predetermined ratio may be set to be, for example, 10%, i.e., 5 ohm. However, the disclosure is not limited thereto, and may be set to various values for impedance matching.

The following Equation 1 defines the characteristic impedance $Z_1$ according to the stretchable printed circuit board 200 in the state (a).

<Equation 1>

$$Z_1 = \sqrt{L_1 / C_1}$$

wherein, $L_1$ may be an induction coefficient generated in the stretchable printed circuit board 200 in the state (a), and $C_1$ may be a capacitance generated in the stretchable printed circuit board 200 in the state (a). The unit of the characteristic impedance $Z_1$ is ohm $(\Omega)$.

The following Equation 2 defines the characteristic impedance $Z_2$ according to the stretchable printed circuit board 200 in the state (b).

<Equation 2>

$$Z_2 = \sqrt{L_2 / C_2}$$

wherein, $L_2$ may be an induction coefficient generated in the stretchable printed circuit board 200 in the state (b), and $C_2$ may be a capacitance generated in the stretchable printed circuit board 200 in the state (b). The unit of the characteristic impedance $Z_2$ is ohm $(\Omega)$. $L_1$, $C_1$, $L_2$, $C_2$, $Z_1$, and $Z_2$ derived from the stretchable printed circuit board 200 will be described below with reference to FIG. 6.

FIG. 6 is a cross-sectional view (a) of the stretchable printed circuit board (e.g., the stretchable printed circuit board 200 of FIG. 1) before stretching and a cross-sectional view (b) of the stretchable printed circuit board 200 after stretching, according to an embodiment of the disclosure. Since the cross-sectional view in the state (a) of FIG. 6 corresponds, in all or part, to those of the cross-sectional view of FIG. 2, any redundant description will be omitted and description will be focused on the differences.

Referring to FIG. 6, the stretchable printed circuit board 200 in the state (a) may have a width $d_1$ and a height $h_1$. The stretchable printed circuit board 200 in the state (b) may have a width $d_2$ and a height $h_2$. The width $d_2$ may be equal to or less than $d_1$. The height $h_2$ may be equal to or less than $h_1$.

According to an example, in the state (b), at least a portion or all of the dielectric member 210, the adhesive member 220, the shielding member 230, the shielding member 240, or the wiring members 250 and 260 may contract relatively compared to the state (a). For example, the height or width of the wiring members 250 and 260 may be reduced, or the distance between the wiring members 250 and 260 may be reduced. When the height or width of the wiring members 250 and 260 is reduced, the induction coefficient $L_2$ according to the current flow to the wiring members 250 and 260 may be increased. When the distance between the wiring members 250 and 260 is reduced, the capacitance $C_2$ may be increased as electric charges move to the wiring members 250 and 260. The characteristic impedance $Z_2$ may be set as the induction coefficient $L_2$ and the capacitance $C_2$ are changed. In connection with the above, description will be made in greater detail with reference to FIG. 7.

FIG. 7 is an enlarged view of a portion of a cross-sectional view (e.g., a portion III of FIG. 6) according to an embodiment of the disclosure. The two cross-sectional views of the states (a) and (b) only illustrate the second ground wiring 253, the third ground wiring 255, the third signal wiring 263, and the fourth signal wiring 264, but they may be understood throughout the wiring members 250 and 260 included in the stretchable printed circuit board 200.

Referring to FIG. 7, in the state (a), the third signal wiring 263 may have a width $w_1$ and a height $t_1$. The third signal wiring 263 may be spaced apart from the fourth signal wiring 264 by $s_1$. The induction coefficient of the third signal wiring 263 may be determined by the width $w_1$, the height $t_1$, and the length (e.g., the length $l_1$ of FIG. 5) of the third signal wiring 263. The capacitance of the third signal wiring 263 may be determined by the width $w_1$, the height $t_1$, and the length $l_1$ of the third signal wiring 263 and the separation distance $s_1$ between the third signal wiring 263 and the fourth signal wiring 264. In this way, the induction coefficient and capacitance of the remaining wiring members 250 and 260 including the third signal wiring 263 may be determined, and the induction coefficient $L_1$ and capacitance $C_1$ of the stretchable printed circuit board 200 may be derived by synthesizing the induction coefficient and capacitance in each of the determined wiring members 250 and 260. For example, the characteristic impedance $Z_1$ of the stretchable printed circuit board 200 in the state (a) may be calculated by the above Equation 1 with the induction coefficient L1 and capacitance $C_1$.

According to an example, in the state (b), the third signal wiring 263 may have a width $w_2$ and a height $t_2$. The third signal wiring 263 may be spaced apart from the fourth signal wiring 264 by $s_2$. For example, $w_2$ may have a value equal to or less than $w_1$. $t_2$ may have a value equal to or less than $t_1$. $s_2$ may have a value equal to or less than $s_1$. The induction coefficient of the third signal wiring 263 may be determined by the width $w_2$, the height $t_2$, and the length (e.g., the length $l_1$ of FIG. 5) of the third signal wiring 263. The capacitance of the third signal wiring 263 may be determined by the width $w_2$, the height $t_2$, and the length $l_2$ of the third signal wiring 263, and the separation distance $s_2$ between the third signal wiring 263 and the fourth signal wiring 264. In this way, the induction coefficient and the capacitance of the remaining wiring members 250 and 260 including the third signal wiring 263 may be determined, and then the induction coefficient $L_2$ and the capacitance $C_2$ of the stretchable printed circuit board 200 may be derived by synthesizing the induction coefficient and the capacitance in each of the determined wiring members 250 and 260. For example, the characteristic impedance $Z_2$ of the stretchable printed circuit board 200 in the state (b) may be calculated by the Equation 2 with the induction coefficient $L_2$ and the capacitance $C_2$.

According to an example, when comparing the characteristic impedances $Z_1$ of the stretchable printed circuit board 200 in the state (a) with the characteristic impedances $Z_2$ of the stretchable printed circuit board 200 in the state (b), $Z_2$ may be less than or equal to $Z_1$. Therefore, the length ($l_1$, $l_2$), the width ($w_1$, $w_2$) and the height ($h_1$, $h_2$) of the wiring members 250 and 260 or the inter-wiring distance ($s_1$, $s_2$) before and after the stretching may be considered so that the difference between $Z_2$ and $Z_1$ is maintained at a predetermined ratio (e.g., 10% of the reference impedance) with respect to the reference impedance (e.g., 50 ohms).

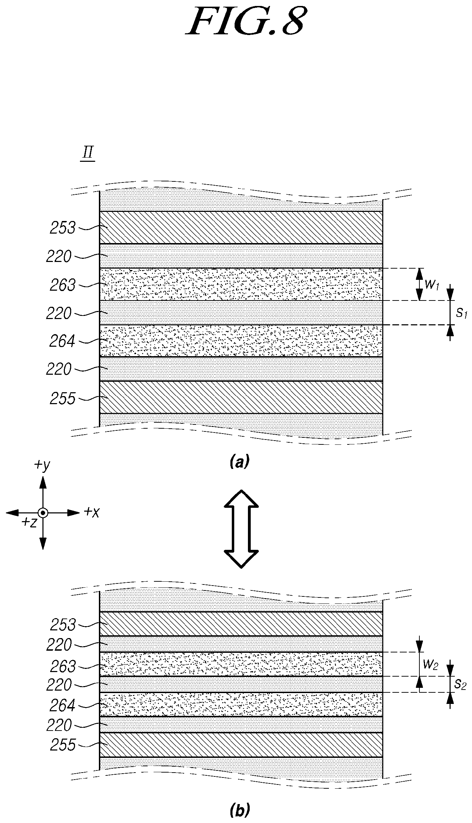

FIG. 8 illustrates a longitudinal cross-sectional view (a) of the stretchable printed circuit board 200 before stretching and a longitudinal cross-sectional view (b) of the stretchable printed circuit board 200 after stretching, according to an embodiment of the disclosure. The view (a) is an enlarged view of a portion (II) of FIG. 4, and in the following description, redundant explanations may be omitted and the description will focus on the differences. Further, the two longitudinal cross-sectional views (a) and (b) illustrated above only show the second ground wiring 253, the third ground wiring 255, the third signal wiring 263, and the fourth signal wiring 264 but it is to be understood throughout the wiring members 250 and 260 included in the stretchable printed circuit board 200.

Referring to FIG. 8, in the state (a), the third signal wiring 263 may have a width $w_1$. Although not shown herein, the third signal wiring 263 may have a length of $l_1$ in a longitudinal direction thereof. The third signal wiring 263 may be spaced apart from the fourth signal wiring 264 by $s_1$. The induction coefficient of the third signal wiring 263 may be determined by the width $w_1$, the height (e.g., the height $t_1$ of FIG. 7), and the length $l_1$ of the third signal wiring 263. The capacitance of the third signal wiring 263 may be determined by the width $w_1$, the height $t_1$, and the length $l_1$ of the third signal wiring 263, and the separation distance $s_1$ between the third signal wiring 263 and the fourth signal wiring 264. In this way, the induction coefficient and the capacitance of the remaining wiring members 250 and 260 including the third signal wiring 263 may be determined, and then the induction coefficient $L_1$ and the capacitance $C_1$ of the stretchable printed circuit board 200 may be derived by synthesizing the induction coefficient and the capacitance in each of the determined wiring members 250 and 260. For example, the characteristic impedance $Z_1$ of the stretchable printed circuit board 200 in the state (a) may be calculated by Equation 1 with the induction coefficient $L_1$ and the capacitance $C_1$.

According to an example, the third signal wiring 263 in the state (b) may have a width $w_2$. Although not shown herein, the third signal wiring 263 may have a length of $l_2$ in the longitudinal direction of the third signal wiring 263. The third signal wiring 263 may be spaced apart from the fourth signal wiring 264 by $s_2$. For example, $w_2$ may have a value equal to or less than $w_1$. $l_2$ may have a value equal to or greater than $l_1$. $s_2$ may have a value equal to or less than $s_1$. The induction coefficient of the third signal wiring 263 may be determined by the width $w_2$, the height $t_2$ (e.g., the height $t_2$ of FIG. 7), and the length $l_2$ of the third signal wiring 263. The capacitance of the third signal wiring 263 may be determined by the width $w_2$, the height $t_2$, and the length $l_2$ of the third signal wiring 263, and the separation distance $s_2$ between the third signal wiring 263 and the fourth signal wiring 264. In this way, the induction coefficient and the capacitance of the remaining wiring members 250 and 260 including the third signal wiring 263 may be determined, and then the induction coefficient $L_2$ and capacitance $C_2$ of the stretchable printed circuit board 200 may be derived by synthesizing the induction coefficient and the capacitance in each of the determined wiring members 250 and 260. For example, the characteristic impedance $Z_2$ of the stretchable printed circuit board 200 in the state (b) may be calculated by the Equation 2 with the induction coefficient $L_2$ and the capacitance $C_2$.

According to an example, when comparing the characteristic impedances $Z_1$ of the stretchable printed circuit board 200 in the state (a) with the characteristic impedances $Z_2$ of the stretchable printed circuit board 200 in the state (b), $Z_2$ may be less than or equal to $Z_1$. Therefore, the length ($l_1$, $l_2$), the width ($w_1$, $w_2$) and the height ($h_1$, $h_2$) of the wiring members 250 and 260, or the inter-wiring distance ($s_1$, $s_2$) before and after the stretching may be considered such that the difference between $Z_2$ and $Z_1$ is maintained at a predetermined ratio (e.g., 10% of the reference impedance) with respect to the reference impedance (e.g., 50 ohms).

FIG. 9 is an exploded perspective view of an electronic device 1 according to an embodiment.

Referring to FIG. 9, for example, the electronic device 1 may include a display unit 920, a bracket assembly 930, a substrate 940, a first housing structure 911, a second housing structure 912, a first back cover 914, and a second back cover 915. In the present disclosure, the display unit 920 may be referred to as a display module or a display assembly.

The display unit 920 may include a display 921, and one or more plates or layers 922 on which the display 921 is seated. As an example, the plate 922 may be disposed between the display 921 and the bracket assembly 930. The display 921 may be disposed on at least a portion of one surface (e.g., an upper surface with respect to FIG. 9) of the plate 922. The plate 922 may be formed in a shape corresponding to the display 921. For example, a partial area of the plate 922 may be formed in a shape corresponding to a notch 9214 of the display 921.

The bracket assembly 930 may include a first bracket 931, a second bracket 932, a hinge structure (not shown) disposed between the first bracket 931 and the second bracket 932, a hinge cover 913 covering the hinge structure when viewed from the outside, and a wiring member 933 (e.g., a flexible printed circuit board (FPCB) crossing the first bracket 931 and the second bracket 932.

According to an example, the bracket assembly 930 may be disposed between the plate 922 and the substrate 940. For example, the first bracket 931 may be disposed between a first area 9212 of the display 921 and a first substrate 941. The second bracket 932 may be disposed between a second area 9213 of the display 921 and a second substrate 942.

According to an example, a wiring member 933 and at least a portion of the hinge structure may be disposed in the bracket assembly 930. The wiring member 933 may be disposed in a direction (e.g., the x-axis direction) crossing the first bracket 931 and the second bracket 932. The wiring member 933 may be disposed in a direction (e.g., a longitudinal direction (x-axis direction) of the cable 100 in FIG. 1) perpendicular to a folding axis D of a folding area 9211 of the electronic device 1.

The substrate 940 may include a first substrate 941 disposed on a side of the first bracket 931 and a second substrate 942 disposed on a side of the second bracket 932, as described above. The first substrate 941 and the second substrate 942 may be disposed inside a space formed by the bracket assembly 930, the first housing structure 911, the second housing structure 912, the first back cover 914, and the second back cover 915. Components for implementing various functions of the electronic device 1 may be mounted on the first substrate 941 and the second substrate 942.

The first housing structure 911 and the second housing structure 912 may be assembled to be coupled to both sides of the bracket assembly 930 with the display unit 920 coupled to the bracket assembly 930. As described later, the first housing structure 911 and the second housing structure 912 may slide on both sides of the bracket assembly 930 to be coupled to the bracket assembly 930.

According to an example, the first housing structure 911 may include a first rotation support surface 9111, and the second housing structure 912 may include a second rotation support surface 9121 corresponding to the first rotation support surface 911. The first rotation support surface 9111 and the second rotation support surface 9121 may include a curved surface corresponding to a curved surface included in the hinge cover 913.

According to an example, when the electronic device 1 is in an unfolded state, the first rotation support surface 9111 and the second rotation support surface 9121 may cover the hinge cover 913, such that the hinge cover 913 may not be exposed or minimally exposed to the rear of the electronic device 1. Meanwhile, when the electronic device 1 is in a folded state, the first rotation support surface 9111 and the second rotation support surface 9121 may rotate along a curved surface included in the hinge cover 913, so that the hinge cover 913 may be exposed to the rear surface of the electronic device 1 maximally.

According to an example, the wiring member 933 may be implemented as the cable 100 in the present disclosure. The cable 100 may include a first cable 100a or a second cable 100b. The cable 100 may electrically or physically connect the first substrate 941 and the second substrate 942. For example, although not shown herein, a connection terminal provided at the other end 311 of the first FPCB (e.g., the first FPCB 310 of FIG. 1) may be coupled to a connection port provided at the first substrate 941, or a connection terminal provided at the other end 323 of the second FPCB (e.g., the second FPCB 320 of FIG. 1) may be coupled to a connection port provided at the second substrate 941.

According to an example, the cable 100 may correspond to the maximum contraction state (e.g., the state (a) of FIG. 5), when the electronic device 1 is in the folded state, and the cable 100 may correspond to the maximum stretching state (e.g., the state (b) of FIG. 5), when the electronic device 1 is in the unfolded state.

According to an example, the cable 100 is not limited to the first cable 100a or the second cable 200a as illustrated above, but may be applied to a cable for connecting electrical components provided in the electronic device 1 or transmitting signals. In particular, the cable 100 may be provided in a stretched or bent portion or area of the electronic device 1.

According to an example, the electronic device 1 is not limited to a foldable device that is foldable to both sides as illustrated, but may be also applied in various ways to electronic devices that is foldable up and down, electronic devices with a rollable display, and wearable devices (e.g., bracelet-type (or anklet-type) electronic devices, necklace-type electronic devices, ring-type electronic devices, AR glasses, head mounted display (HMD) devices or the like).

A cable 100 according to an embodiment of the disclosure may include a stretchable circuit board 200 configured to be stretched by an external force in a longitudinal direction in which a first pad member 331 and a second pad member 333 move away from each other, wherein one end 313 of a first printed circuit board 310 is bonded by the first pad member 331 and one end of a second printed circuit board 320 is bonded by the second pad member 333. The stretchable circuit board 200 may include a plurality of wiring members 250 and 260 configured to be stretched by the external force, one side of another side of which are electrically coupled to the first pad member 331 and the second pad member 333, respectively, on an upper surface of a dielectric member 210 provided inside a cover member 240, wherein the plurality of wiring members 250 and 260 may be arranged to be spaced apart from each other by a predetermined interval (s) in a width direction perpendicular to the longitudinal direction.

In the cable 100 according to an embodiment of the disclosure, the first printed circuit board 310 or the second printed circuit board 320 may have a width relatively greater than a width (w) of the stretchable circuit board 200.

In the cable 100 according to an embodiment of the disclosure, the first printed circuit board 310 or the second printed circuit board 320 may be a flexible printed circuit board (FPCB).

In the cable 100 according to an embodiment of the disclosure, the stretchable printed circuit board 200 may include an adhesive member 220 configured to cover the plurality of wiring members 250 and 260 with a predetermined thickness, inside the cover member 240 and a shielding member 230 configured to be bonded to an upper part of the adhesive member 220, inside the cover member 240.

In the cable 100 according to an embodiment of the disclosure, the first pad member 331 may be configured to bond the first printed circuit board 310 and the stretchable printed circuit board 200 by an anisotropic conductive film (ACF) method or a ball grid array (BGA) method, and the second pad member 333 may be configured to bond the second printed circuit board 320 and the stretchable printed circuit board 200 by the ACF method or the BGA method.

In the cable 100 according to an embodiment of the disclosure, the plurality of wiring members 250 and 260 may be configured such that a conductive material 280 exists in powder form at a predetermined density in a stretchable material 270.

In the cable 100 according to an embodiment of the disclosure, the stretchable material 270 may include an epoxy-based, polymer-based, or polyurethane-based material, and the conductive material 280 may include a metal material having a relatively high conductivity.

In the cable 100 according to an embodiment of the disclosure, the dielectric member 210 and the shielding member 230 may be made of a non-conductive material, and the non-conductive material may include silicon rubber or polyimide.

In the cable 100 according to an embodiment of the disclosure, at least one of a separation distance (s) of the plurality of wiring members 250 and 260 or a width (w) or a height (h) of the plurality of wiring members 250 and 260 may be determined within a range that a difference between an impedance before stretching and an impedance after stretching by the external force does not exceed a threshold level.

In the cable 100 according to an embodiment of the disclosure, the plurality of wiring members 250 and 260 may be configured such that a first wiring member 260 for transmitting electrical signals between the first printed circuit board 310 and the second printed circuit board 320 and a second wiring member 250 for grounding are alternately disposed.

An electronic device 1 according to an embodiment of the disclosure may include a display 920, housings 911 and 912, at least one bracket 930, at least one substrate 940, at least one cable for connecting the at least one substrate 940 or connecting electrical components provided on the at least one substrate 940, and rear covers 914 and 915. Here, the at least one cable may include a cable 100 stretching in a predetermined direction. The cable 100 stretching in the predetermined direction may include a stretchable circuit board 200 configured to be stretched by an external force in a longitudinal direction in which a first pad member 331 and a second pad member 333 move away from each other, wherein one end 313 of a first printed circuit board 310 is bonded by the first pad member 331 and one end of a second printed circuit board 320 is bonded by the second pad member 333. The stretchable circuit board 200 may include a plurality of wiring members 250 and 260 configured to be stretched by the extenal force, one side and another side of which are electrically coupled to the first pad member 331 and the second pad member 333, respectively, on an upper surface of a dielectric member 210 provided inside a cover member 240, wherein the plurality of wiring members 250 and 260 may be arranged to be spaced apart from each other by a predetermined interval (s) in a width direction perpendicular to the longitudinal direction.

In the electronic device 1 according to an embodiment of the disclosure, the first printed circuit board 310 or the second printed circuit board 320 may have a width relatively greater than a width (w) of the stretchable printed circuit board 200.

In the electronic device 1 according to an embodiment of the disclosure, the first printed circuit board 310 or the second printed circuit board 320 may be a flexible printed circuit board (FPCB).

In the electronic device 1 according to an embodiment of the disclosure, the stretchable printed circuit board 200 may include an adhesive member 220 configured to cover a plurality of wiring members 250 and 260 with a predetermined thickness, inside the cover member 240, and a shielding member 230 configured to be bonded to an upper part of the adhesive member 220, inside the cover member 240.

In the electronic device 1 according to an embodiment of the disclosure, the first pad member 331 may be configured to bond the first printed circuit board 310 and the stretchable printed circuit board 200 by an anisotropic conductive film (ACF) method or a ball grid array (BGA) method, and the second pad member 333 may be configured to bond the second printed circuit board 320 and the stretchable printed circuit board 200 by the ACF method or the BGA method.

In the electronic device 1 according to an embodiment of the disclosure, the plurality of wiring members 250 and 260 may be configured such that a conductive material 280 exists in powder form at a predetermined density in a stretchable material 270.

In the electronic device 1 according to an embodiment of the disclosure, the stretchable material 270 may include an epoxy-based, polymer-based, or polyurethane-based material, and the conductive material 280 may include a metal material having a relatively high conductivity.

In the electronic device 1 according to an embodiment of the disclosure, the dielectric member 210 and the shielding member 230 may be made of a nonconductive material, and the non-conductive material may include silicon rubber or polyimide.

In the electronic device 1 according to an embodiment of the disclosure, at least one of a separation distance (s) of the plurality of wiring members 250 and 260 or a width (w) or a height (h) of the plurality of wiring members 250 and 260 may be determined to be within a range that a difference between an impedance before stretching and an impedance after stretching by the external force does not exceed a threshold level.

In the cable 100 according to an embodiment of the disclosure, the plurality of wiring members 250 and 260 may be configured such that a first wiring member 260 for transmitting electrical signals between the first printed circuit board 310 and the second printed circuit board 320 and a second wiring member 250 for grounding are alternately disposed.

The device according to various embodiments disclosed herein may be one of various types of devices. The devices may include, for example, a display device, a portable communication device (e.g., a smartphone), a computer device, a portable multimedia device, a portable medical device, a camera, a wearable device, or a home appliance. The devices according to an embodiment of the disclosure are not limited to those described above.

It should be appreciated that various embodiments and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B", "A, B, or C", "at least one of A, B, and C", and "at least one of A, B, or C" may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may be interchangeably used with other terms, for example, 'logic', 'logic block', 'component', 'part', 'portion', or 'circuit'. A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., a program) including one or more instructions that are stored in a storage medium (e.g., an internal memory or an external memory) that is readable by a machine (e.g., the electronic device 1). For example, a processor of the machine (e.g., the electronic device 1) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments disclosed herein may be included and provided in a computer program product.

The computer program product may be traded as a product between a seller and a buyer. The computer program product may be distributed in the form of a machine-readable storage medium (e.g., a compact disc read only memory (CD-ROM)), or be distributed (e.g., downloaded or uploaded) online via an application store (e.g., PlayStore™), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

**Claims**

1.  A cable (100) used in an electronic device (1), comprising:

    a stretchable circuit board (200) configured to be stretched by an external force in a longitudinal direction in which a first pad member (331) and a second pad member (333) move away from each other, wherein one end (313) of a first printed circuit board (310) is bonded by the first pad member (331) and one end (321) of a second printed circuit board (320) is bonded by the second pad member (333),
    wherein the stretchable circuit board (200) comprises a plurality of wiring members (250, 260) configured to be stretched by the external force, one side and another side of which are electrically coupled to the first pad member (331) and the second pad member (333), respectively, on an upper surface of a dielectric member (210) provided inside a cover member (240),

wherein the plurality of wiring members (250, 260) are arranged to be spaced apart from each other by a predetermined interval (s) in a width direction perpendicular to the longitudinal direction.

2. The cable (100) of claim 1, wherein the first printed circuit board (310) or the second printed circuit board (320) has a width relatively larger than a width (w) of the stretchable circuit board (200).

3. The cable (100) of claim 1, wherein the first printed circuit board (310) or the second printed circuit board (320) is a flexible printed circuit board.

4. The cable (100) of claim 1, wherein the stretchable printed circuit board (200) comprises:

    an adhesive member (220) configured to cover the plurality of wiring members (250, 260) with a predetermined thickness, inside the cover member (240); and
    a shielding member (230) configured to be bonded to an upper part of the adhesive member (220), inside the cover member (240).

5. The cable (100) of claim 1,

    wherein the first pad member (331) is configured to bond the first printed circuit board (310) and the stretchable printed circuit board (200) by an anisotropic conductive film (ACF) method or a ball grid array (BGA) method, and
    wherein the second pad member (333) is configured to bond the second printed circuit board (320) and the stretchable printed circuit board (200) by the ACF method or the BGA method.

6. The cable (100) of claim 1, wherein the plurality of wiring members (250, 260) are configured such that a conductive material (280) exists in powder form at a predetermined density in a stretchable material (270).

7. The cable (100) of claim 6,

    wherein the stretchable material (270) comprises an epoxy-based, polymer-based, or polyurethane-based material, and
    wherein the conductive material (280) comprises a metal material having a relatively high conductivity.

8. The cable (100) of claim 4,

    wherein the dielectric member (210) and the shielding member (230) are made of a non-conductive material, and

wherein the non-conductive material comprises silicon rubber or polyimide.

9. The cable (100) of claim 1, wherein at least one of a separation distance (s) of the plurality of wiring members (250, 260) or a width (w) or a height (h) of the plurality of wiring members (250, 260) is determined to be within a range that a difference between an impedance before stretching and an impedance after stretching by the external force does not exceed a threshold level.

10. The cable (100) of claim 1, wherein the plurality of wiring members (250, 260) are configured such that a first wiring member (260) for transmitting electrical signals between the first printed circuit board (310) and the second printed circuit board (320) and a second wiring member (250) for grounding are alternately disposed.

11. An electronic device (1) comprising:

    a display (920);
    housings (911, 912);
    at least one bracket (930);
    at least one substrate (940);
    at least one cable for connecting the at least one substrate (940) or connecting electrical components provided on the at least one substrate (940); and
    rear covers (914, 915),
    wherein the at least one cable comprises a cable (100) stretching in a predetermined direction;
    wherein the cable (100) stretching in the predetermined direction comprises a stretchable circuit board (200) configured to be stretched by an external force in a longitudinal direction in which a first pad member (331) and a second pad member (333) move away from each other,
    wherein one end (313) of a first printed circuit board (310) is bonded by the first pad member (331) and one end (321) of a second printed circuit board (320) is bonded by the second pad member (333);
    wherein the stretchable circuit board (200) comprises a plurality of wiring members (250, 260) configured to be stretched by the external force, one side and another side of which are electrically coupled to the first pad member (331) and the second pad member (333), respectively, on an upper surface of a dielectric member (210) provided inside a cover member (240); and
    wherein the plurality of wiring members (250, 260) are arranged to be spaced apart from each other by a predetermined interval (s) in a width direction perpendicular to the longitudinal direction.

**12.** The electronic device (1) of claim 11,

wherein the first printed circuit board (310) or the second printed circuit board (320) has a width relatively larger than a width (w) of the stretchable circuit board (200), and
wherein the first printed circuit board (310) or the second printed circuit board (320) is a flexible printed circuit board.

**13.** The electronic device (1) of claim 11, wherein the stretchable printed circuit board (200) comprises:

an adhesive member (220) configured to cover the plurality of wiring members (250, 260) with a predetermined thickness, inside the cover member (240); and
a shielding member (230) configured to be bonded to an upper part of the adhesive member (220), inside the cover member (240),
wherein the dielectric member (210) and the shielding member (230) are made of a non-conductive material,
wherein the non-conductive material comprises silicon rubber or polyimide.

**14.** The electronic device (1) of claim 11,

wherein the first pad member (331) is configured to bond the first printed circuit board (310) and the stretchable printed circuit board (200) by an anisotropic conductive film (ACF) method or a ball grid array (BGA) method, and
wherein the second pad member (333) is configured to bond the second printed circuit board (320) and the stretchable printed circuit board (200) by the ACF method or the BGA method.

**15.** The electronic device (1) of claim 11,

wherein the plurality of wiring members (250, 260) are configured such that a conductive material (280) exists in powder form at a predetermined density in a stretchable material (270);
wherein the stretchable material (270) comprises an epoxy-based, polymer-based, or polyurethane-based material; and
wherein the conductive material (280) comprises a metal material having a relatively high conductivity.

# FIG.1

# FIG.2

# FIG.3

# FIG.4

# FIG.5

(a)

(b)

# *FIG.6*

*(a)*

*(b)*

# FIG.7

(a)

(b)

# FIG.8

*(a)*

*(b)*

# FIG.9

<div align="center">

**INTERNATIONAL SEARCH REPORT**

</div>

| | International application No. |
|---|---|
| | **PCT/KR2024/095008** |

**A. CLASSIFICATION OF SUBJECT MATTER**

**H01B 7/08**(2006.01)i; **H01R 12/78**(2011.01)i; **H04M 1/02**(2006.01)i; **H01R 12/77**(2011.01)i; **H01B 3/46**(2006.01)i; **H01B 3/30**(2006.01)i; **H05K 1/14**(2006.01)i; **H05K 3/28**(2006.01)i

According to International Patent Classification (IPC) or to both national classification and IPC

**B. FIELDS SEARCHED**

Minimum documentation searched (classification system followed by classification symbols)

H01B 7/08(2006.01); C08L 75/04(2006.01); G06N 10/00(2019.01); H01B 1/22(2006.01); H01L 39/24(2006.01); H04M 1/02(2006.01); H05K 1/02(2006.01); H05K 3/12(2006.01); H05K 5/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 신장(stretch), 플렉서블(flexible), 케이블(cable), 배선(wiring), 인쇄회로기판 (printed circuit board)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2020-0019534 A (SAMSUNG ELECTRONICS CO., LTD. et al.) 24 February 2020 (2020-02-24) See paragraphs [0043]-[0055], [0070]-[0100] and [0137]-[0138]; and figures 1-6c and 11-12. | 1-15 |
| Y | KR 10-2018-0062243 A (SAMSUNG ELECTRONICS CO., LTD. et al.) 08 June 2018 (2018-06-08) See paragraphs [0058]-[0068] and [0098]-[0099]; and figures 5 and 9-14. | 1-15 |
| A | KR 10-2020-0021172 A (SAMSUNG ELECTRONICS CO., LTD.) 28 February 2020 (2020-02-28) See paragraphs [0093]-[0118]; and figures 8c-9. | 1-15 |
| A | JP 2020-053619 A (SUMITOMO BAKELITE CO., LTD.) 02 April 2020 (2020-04-02) See entire document. | 1-15 |
| A | US 2021-0028346 A1 (GOOGLE LLC) 28 January 2021 (2021-01-28) See entire document. | 1-15 |

☐ Further documents are listed in the continuation of Box C.    ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **08 April 2024** | **08 April 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/095008**

| Patent document cited in search report | | | Publication date (day/month/year) | Patent family member(s) | | | Publication date (day/month/year) |
|---|---|---|---|---|---|---|---|
| KR | 10-2020-0019534 | A | 24 February 2020 | KR | 10-2527295 | B1 | 02 May 2023 |
| | | | | US | 11523507 | B2 | 06 December 2022 |
| | | | | US | 2021-0329784 | A1 | 21 October 2021 |
| | | | | WO | 2020-036383 | A1 | 20 February 2020 |
| KR | 10-2018-0062243 | A | 08 June 2018 | EP | 3330327 | A1 | 06 June 2018 |
| | | | | EP | 3330327 | B1 | 12 July 2023 |
| | | | | US | 10392518 | B2 | 27 August 2019 |
| | | | | US | 2018-0148584 | A1 | 31 May 2018 |
| KR | 10-2020-0021172 | A | 28 February 2020 | CN | 112586091 | A | 30 March 2021 |
| | | | | EP | 3804479 | A1 | 14 April 2021 |
| | | | | EP | 3804479 | A4 | 25 August 2021 |
| | | | | KR | 10-2575550 | B1 | 07 September 2023 |
| | | | | US | 10736211 | B2 | 04 August 2020 |
| | | | | US | 2020-0060020 | A1 | 20 February 2020 |
| | | | | WO | 2020-040503 | A1 | 27 February 2020 |
| JP | 2020-053619 | A | 02 April 2020 | JP | 7392258 | B2 | 06 December 2023 |
| US | 2021-0028346 | A1 | 28 January 2021 | AU | 2017-430443 | A1 | 26 September 2019 |
| | | | | AU | 2017-430443 | B2 | 29 October 2020 |
| | | | | AU | 2017-430443 | C1 | 06 May 2021 |
| | | | | CA | 3058731 | A1 | 14 March 2019 |
| | | | | CA | 3058731 | C | 05 July 2022 |
| | | | | CN | 110520873 | A | 29 November 2019 |
| | | | | CN | 110520873 | B | 10 October 2023 |
| | | | | CN | 117273160 | A | 22 December 2023 |
| | | | | EP | 3580701 | A1 | 18 December 2019 |
| | | | | EP | 3580701 | B1 | 13 December 2023 |
| | | | | JP | 2020-520084 | A | 02 July 2020 |
| | | | | JP | 6852187 | B2 | 31 March 2021 |
| | | | | KR | 10-2019-0123313 | A | 31 October 2019 |
| | | | | KR | 10-2021-0055806 | A | 17 May 2021 |
| | | | | KR | 10-2252438 | B1 | 14 May 2021 |
| | | | | KR | 10-2389777 | B1 | 22 April 2022 |
| | | | | US | 11557709 | B2 | 17 January 2023 |
| | | | | US | 2023-0130578 | A1 | 27 April 2023 |
| | | | | WO | 2019-050525 | A1 | 14 March 2019 |

Form PCT/ISA/210 (patent family annex) (July 2022)